# EUROPEAN PATENT APPLICATION

(11) **EP 2 110 867 A1**
(43) Date of publication of application: **21.10.2009**
(21) Application number: 08703392.4
(22) Date of filing: 17.01.2008
(51) Int. Cl.: H01L 43/00, G01R 33/06, G01R 33/09, H01L 43/08

(54) **MAGNETIC SENSOR ELEMENT AND METHOD FOR MANUFACTURING THE SAME**

(30) Priority: 17.01.2007 JP 2007007979; 11.01.2008 JP 2008004880
(71) Applicant: FUJIKURA LTD., Kohtoh-ku Tokyo 135-8512 (JP); Akita Prefecture, Akita-shi, Akita 010-8570 (JP)
(72) Inventor: OHMORI, Kenichi, Chiba 285-8550 (JP); AIZAWA, Takuya, Chiba 285-8550 (JP); NAKAO, Osamu, Chiba 285-8550 (JP); TAN, Kenji, Akita 010-1623 (JP)
(74) Representative: Cabinet Plasseraud
(86) International application number: PCT/JP2008/050537
(87) International publication number: WO 2008/088021

(57) **Abstract**

A magnetic sensor element has a hard magnetic film 2 formed on a nonmagnetic substrate 1, an insulating layer 3 covering the top of the hard magnetic film 2, and a soft magnetic film 4 formed on the insulating layer 3. The magnetization direction of the hard magnetic film 2 has an angle θ relative to the longitudinal direction of the soft magnetic film 4. It is preferable that, in plan view when viewing the nonmagnetic substrate 1 from above, the hard magnetic film 2 is broader than the region in which the soft magnetic film 4 is formed, and all of the region in which the soft magnetic film 4 is entirely overlaps with the region in which the hard magnetic film 2 is formed. According to the present invention, a magnetic sensor element for which a constant bias magnetic field is obtained can be provided.

## Description

### TECHNICAL FIELD

The present invention relates to a thin film magnetoimpedance effect element, known as a high-sensitivity magnetic sensor, and to other magnetic sensor elements. Conventional elements of this type have, for example, been utilized in electronic compasses which detect the earth's magnetic field and indicate the compass directions, in rotary encoders, for biological magnetic measurements, and in other areas.

This application claims priority from Japanese Patent Application No. 2007-007979, filed January 17, 2007, and from Japanese Patent Application No. 2008-004880, filed January 11, 2008, the contents of which are incorporated herein by reference.

### BACKGROUND ART

Magnetoimpedance effect elements substantially have characteristics such that the impedance changes symmetrically in response to positive and negative magnetic fields. Therefore, in order to detect a positive or negative magnetic field near the magnetic field of 0, a bias magnetic field must be applied to the magnetoimpedance effect element so as to change the impedance be linear. As methods for applying the bias magnetic field, methods using wound coils, thin film coils, sheet-shape magnets, bulk magnets, and thin film magnets are known (refer to Patent Documents 1 through 10 and Non-patent Documents 1 and 2).

Problems with these methods are as follows.
1. When applying the bias magnetic field using the wound coil, there are problems in that it is difficult to reduce the size thereof, in that the structure is complex, and in that power consumption is increased.
2. When applying the bias magnetic field using the thin film coil, there are problems in that the structure is complex, and in that power consumption is increased.
3. When applying the bias magnetic field using the sheet-shape magnet or the bulk magnet, there are problems in that control of the magnetic field intensity is difficult, that the assembly process is complex, and that mechanical strength is difficult to obtain.
4. When applying a bias magnetic field using a thin film magnet, there is the problem that control of the magnetic field intensity is difficult.

The reason for the difficulty in controlling the magnetic field intensity when using the magnet to apply the bias magnetic field is that the magnitude of the bias magnetic field is determined due to the characteristics of the magnet, so that it is difficult to correct variations in the bias magnetic field arising from variations in the characteristics of the magnet itself.
Patent Document 1: Japanese Patent No. 3210933
Patent Document 2: Japanese Patent No. 3650575
Patent Document 3: Japanese Patent No. 3656018
Patent Document 4: Japanese Patent No. 3602988
Patent Document 5: Japanese Unexamined Patent Application, Publication No. 2004-333217
Patent Document 6: Japanese Unexamined Patent Application, Publication No. 2002-55148
Patent Document 7: Japanese Unexamined Patent Application, Publication No. 2002-43649
Patent Document 8: Japanese Unexamined Patent Application, Publication No. 2002-43648
Patent Document 9: Japanese Unexamined Patent Application, Publication No. 2002-43647
Patent Document 10: Japanese Unexamined Patent Application, Publication No. 2002-33210
Non-patent Document 1: Journal of the Magnetics Society of Japan, Vol. 21, pp. 649-652, 1997
Non-patent Document 2: Journal of the Magnetics Society of Japan, Vol. 28, pp. 132-135, 2004

### DISCLOSURE OF THE INVENTION

The present invention has been achieved in light of the above circumstances, and an object thereof is to provide a magnetic sensor element from which can obtain a uniform bias magnetic field.

Furthermore, another object of the present invention is to provide a manufacturing method of a magnetic sensor element which can easily correct variations of the bias magnetic field.

In order to achieve these objects, the present invention provides a magnetic sensor element having a hard magnetic film formed on a nonmagnetic substrate, an insulating layer covering the top of the hard magnetic film, and a soft magnetic film formed on the insulating layer; wherein the magnetization direction of the hard magnetic film has an angle relative to the longitudinal direction of the soft magnetic film.

It is preferable that in a magnetic sensor element of the present invention, the region in which the hard magnetic film is formed in plan view when viewing the nonmagnetic substrate from above is broader than the region in which the soft magnetic film is formed, and the region in which the soft magnetic film is formed entirely overlaps with the region in which the hard magnetic film is formed.

In a magnetic sensor element of the present invention, it is preferable that the shape of the hard magnetic film be a circular or an elliptical shape in plan view when viewing the nonmagnetic substrate from above.

It is preferable that the hard magnetic film be a metal film including Co or Fe as the main component, and further including at least one of Pt and Cr.

It is preferable that the hard magnetic film be a metal film including FePt as the main component and having an ordered L10 phase with 35 to 55% of a composition ratio of Pt.

Further, the present invention provides a manufacturing method of a magnetic sensor element having a step of forming a hard magnetic film having in-plane isotropy on a nonmagnetic substrate, an insulating layer covering the top of the hard magnetic film, and a soft magnetic film with a shape in which a longitudinal direction thereof is extended in a planer direction on the insulating layer; a step of imparting a uniaxial anisotropy along the width direction of the soft magnetic film to the soft magnetic film by rotational magnetic field annealing followed by static magnetic field annealing; and a step of magnetizing the hard magnetic film in a direction at an angle relative to the longitudinal direction of the soft magnetic film under a static magnetic field or a pulsed magnetic field.

In a magnetic sensor element of the present invention, the region in which the hard magnetic film is formed is broader than the region in which the soft magnetic film is formed. Accordingly, the effect of a demagnetizing field occurring at the edge portions of the hard magnetic film can be prevented from extending to the soft magnetic film, so that a uniform bias magnetic field can be applied to the soft magnetic film.

Further, since a hard magnetic film is formed below the soft magnetic film, with an insulating layer therebetween, so that by means of the magnetic field generated by the hard magnetic film, a bias magnetic field can be applied to the soft magnetic film without supplying electric power. By this means, linear output can be obtained near the magnetic field of 0. Since the hard magnetic film over a range broader than the soft magnetic film is arranged on the lower side of the soft magnetic film, when establishing electrical continuity between the soft magnetic film and the outside, electrical continuity can be established directly from the soft magnetic film, and therefore, it is needless to provide an opening in the insulating layer, so that the number of its manufacturing processes can be reduced.

In a manufacturing method of a magnetic sensor element of the present invention, after imparting a uniaxial anisotropy to the soft magnetic film along the longitudinal direction of the soft magnetic film, magnetizing of the hard magnetic film is performed in a direction at an angle relative to the longitudinal direction of the soft magnetic film under a static magnetic field or a pulsed magnetic field, so that fine adjustment of the angle of the magnetization direction is performed. Accordingly, among the magnetic field generated from the magnetized hard magnetic film, the component of the magnetic field in the longitudinal direction of the soft magnetic film acts as the bias magnetic field. By this means, variations in the output characteristics of the soft magnetic film and variations in the bias magnetic field of the hard magnetic film which are arising from variations in the dimensions and in the characteristics at the time of manufacture of the soft magnetic film and hard magnetic film, can be corrected.

By forming the planar shape of the hard magnetic film in a circular shape or an elliptical shape, lack of homogeneity of the magnetic field at the end portions arising from shape anisotropy can be reduced. By this means, since the absolute value of the magnetic field generated from the hard magnetic film is constant regardless of the angle θ made by the magnetic sensing direction of the magnetic sensor element and the magnetization direction of the hard magnetic film, control of the bias magnetic field by means of the angle θ can be performed more accurately.

By using a hard magnetic film having isotropic magnetic characteristics within the film plane such as FePt, CoPt, or CoCrPt as the hard magnetic film, control of the bias magnetic field by means of the magnetizing direction of the hard magnetic film can be performed more accurately.

### BRIEF DESCRIPTION OF THE DRAWINGS

FIG. 1A is a perspective view showing an embodiment of a magnetic sensor element of the present invention.
FIG. 1B is a plan view showing an embodiment of a magnetic sensor element of the present invention.
FIG. 2 is a cross-sectional view along line S-S in FIG. 1B.
FIG. 3A is a perspective view showing another embodiment of a magnetic sensor element of the present invention.
FIG. 3B is a plan view showing another embodiment of a magnetic sensor element of the present invention.
FIG. 4A is a top view showing the magnetic sensor element of an example of the present invention.
FIG. 4B is a cross-sectional view along line T-T in FIG. 4A, showing the magnetic sensor element of an example of the present invention.
FIG. 5 is a graph showing an example of the magnetic field-impedance characteristics for different film thicknesses of a thin film magnet.
FIG. 6 is a graph showing another example of the magnetic field-impedance characteristics for different magnetizing angles of a thin film magnet.
FIG. 7 is a graph showing an example of the relation between a magnetizing angle and a bias magnetic field.

### EXPLANATION OF REFERENCE SYMBOLS

θ... Angle formed in the surface of nonmagnetic substrate by the magnetic sensing direction of a soft magnetic film and the magnetized direction of a hard magnetic film, 1... Nonmagnetic substrate, 2... Hard magnetic film, 3... Insulating layer, 4... Soft magnetic film, 5... Conductive film, 6... Electrode

### BEST MODE FOR CARRYING OUT THE INVENTION

Hereinafter, the present invention will be explained with reference to the drawings based on the preferred embodiments thereof.

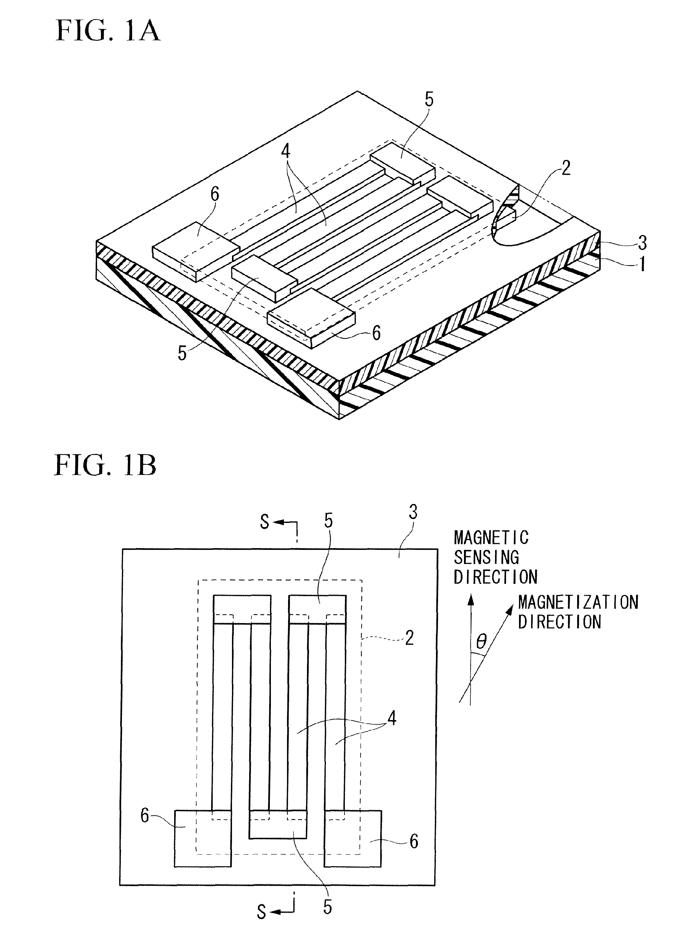

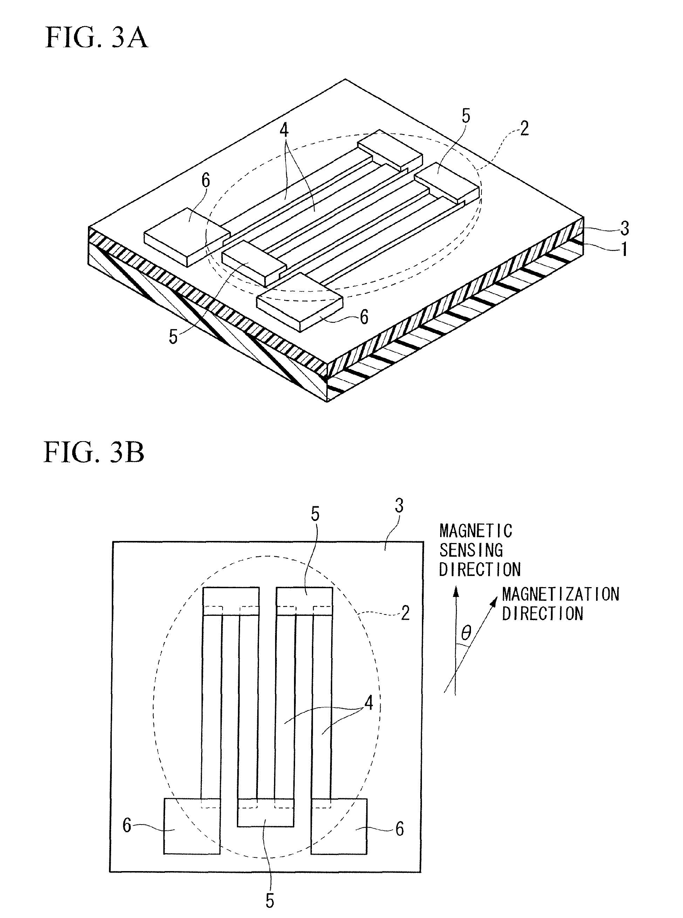

FIG. 1A through FIG. 2 show an embodiment of a magnetic sensor element of the present invention. FIG. 3A and FIG. 3B show another embodiment of a magnetic sensor element of the present invention. In FIG. 1A, a portion of the insulating layer 3 is shown cut away to expose a portion of the hard magnetic film 2 in order to clearly illustrate that the hard magnetic film 2 is formed on the nonmagnetic substrate 1, and oblique lines (hatching) are drawn on the cutout cross-section. In an actual magnetic sensor element, there is no such cutout portion, and the entirety of the hard magnetic film 2 is covered by the insulating layer 3. The magnetic sensor element of this embodiment can, for example, be a magnetoimpedance effect element (MI element), a magnetoresistance element (MR element), a giant magnetoresistance effect element (GMR element), or the like.

The magnetic sensor element of this embodiment has a nonmagnetic substrate 1, a hard magnetic film 2 formed on the nonmagnetic substrate 1, an insulating layer 3 covering the top of the hard magnetic film 2, and a soft magnetic film 4 formed on the insulating layer 3. No constraints in particular are imposed on the nonmagnetic substrate 1, so long as the substrate includes nonmagnetic material. As an example, a semiconductor substrate of silicon or the like, or a glass or other substrate may be used.

The hard magnetic film 2 is a thin film comprising hard magnetic material which has been made a thin film magnet by magnetization, and is provided in order to impart a bias magnetic field to the soft magnetic film 4. As material for forming the hard magnetic film 2, it is preferable that a metal film including Co or Fe as the main component and further including at least one of Pt and Cr; and specific examples of the material metal are hard magnetic metals (alloys) such as FePt, CoPt, CoCrPt. In particular, by using the hard magnetic film having magnetic characteristics which are isotropic in the film plane such as FePt, CoPt, CoCrPt (in these formulas, the alloy composition ratios are not indicated), the bias magnetic field can be controlled more accurately through the direction of magnetization of the hard magnetic film.

As the hard magnetic film 2, a metal film including FePt as the main component and having an ordered L10 phase with 35 to 55% of a composition ratio of Pt (hereafter "FePt having an ordered L10 phase" is possibly abbreviated as "L10FePt" can be used. A metal film made of L10FePt can, for example, be provided by depositing FePt by using sputtering or another method followed by annealing at a temperature of 600°C or higher. It is known that the FePt with a Pt composition ratio of 35 to 55% (and more preferably with a Pt composition ratio of 40 to 55%) becomes the ordered L10 phase (alloy phase) as a result of an appropriate film deposition temperature or annealing conditions, and becomes a thin film magnet with a good squareness ratio which has a large anisotropy energy and in-plane anisotropy. Such L10FePt can be formed by sputtering and is highly compatible with processes for manufacture of thin film MI elements, and enables integration of bias magnets and MI elements.

The insulating layer 3 includes a nonmagnetic insulator so as to perform insulation between the hard magnetic film 2 and the soft magnetic film 4. As the insulating material, a metal oxide such as SiO₂, Al₂O₃ or the like; or a metal nitride such as Si₃N₄, AlN, or the like may be used.

The soft magnetic film 4 is a thin film made of a soft magnetic material which provides uniaxial anisotropy has been imparted. The planar shape of the soft magnetic film 4 is a shape having a longitudinal direction, and specifically is for example a rectangular shape. The uniaxial anisotropy of the soft magnetic film 4 is imparted in the width direction, and the soft magnetic film 4 is sensitive to magnetic fields along the longitudinal direction. No constraints in particular are imposed on the soft magnetic material of the soft magnetic film 4 so long as a uniaxial anisotropy can be imparted; for example, Co₈₅Nb₁₂Zr₃ can be used.

For example, in the case of the magnetic sensor element shown in FIG. 1A and FIG. 1B, a plurality of soft magnetic films 4 having a substantially rectangular planar shape are arranged with the longitudinal direction in parallel and adjacent soft magnetic films 4 are electrically connected in the width direction which is perpendicular to the longitudinal direction (the left-right direction in FIG. 1B) via conducting films 5 so that the end portions thereof form a meander shape. Also, electrodes 6 for performing electrical continuity to the outside are provided at both ends of the plurality of soft magnetic films 4 so as to connect them in series. The conducting films 5 and electrodes 6, can for example, be formed from good conductors such as gold (Au), silver (Ag), copper (Cu), aluminum (Al), or the like.

In the magnetic sensor element of this embodiment, as shown in FIG. 1B, the hard magnetic film 2 is magnetized uniformly in a direction at an angle θ from the magnetic sensing direction, that is, the longitudinal direction of the substantially rectangular shape of the soft magnetic film 4. Furthermore, uniaxial anisotropy is imparted to the soft magnetic film 4 in the width direction of the substantially rectangular shape.

In the magnetic sensor element of this embodiment, as shown in a plan view when viewing the nonmagnetic substrate 1 from above (refer to FIG. 1B and FIG. 3B), the region in which the hard magnetic film 2 is formed has a range wider than the region in which the soft magnetic film 4 is formed, and the entirety of the region in which the soft magnetic film 4 is formed overlaps the region in which the hard magnetic film 2 is formed. By this means, the effect of the demagnetizing field occurring at the edge portions of the hard magnetic film 2 can be prevented from extending to the soft magnetic film 4, so that a uniform bias magnetic field can be applied to the soft magnetic film 4.

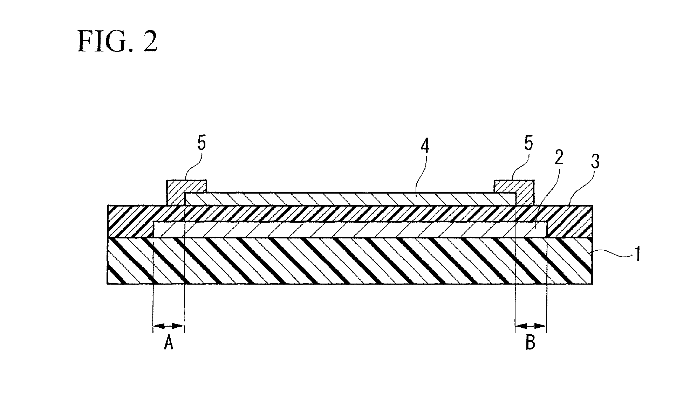

As shown in FIG. 2, it is desirable that the region in which the hard magnetic film 2 is formed be 10 to 200 µm wider than the ends of the soft magnetic film 4 in the longitudinal direction. That is, it is desirable that the distance A along the surface of the substrate from one end of the soft magnetic film 4 to the end of the hard magnetic film 2 in the longitudinal direction be 10 to 200 µm, and that the distance B along the surface of the substrate from the other end of the soft magnetic film 4 to the end of the hard magnetic film 2 in the longitudinal direction be 10 to 200 µm.

Furthermore, since the hard magnetic film 2 is formed below the soft magnetic film 4 with the insulating layer 3 therebetween, a bias magnetic field can be applied to the soft magnetic film 4 by the magnetic field generated by the hard magnetic film 2 without supplying electric power. By this means, linear output can be obtained near the magnetic field of 0.

In the case of the magnetic sensor element shown in FIG. 1B, the planar shape of the hard magnetic film 2 in plan view when viewing the nonmagnetic substrate from above is rectangular. And in the case of the magnetic sensor element shown in FIG. 3B, the planar shape of the hard magnetic film 2 in plan view when viewing the nonmagnetic substrate from above is elliptical.

As shown in FIG. 3A and FIG. 3B, when the planar shape of the hard magnetic film 2 is circular or elliptical, since the shape anisotropy of the hard magnetic film 2 can be reduced, and there is little change in the absolute value of the magnetic field generated from the hard magnetic film 2 when the magnetization is performed at an angle, it is desirable to control the magnitude of the bias magnetic field more accurately.

In the present invention, the rectangular, circular, or elliptical shape of the planar shape of the hard magnetic film 2 may be an approximation. That is, the planar shape includes substantially rectangular, substantially circular, and substantially elliptical shapes.

By employing a circular or nearly circular shape for the planar shape of the hard magnetic film 2 having magnetic characteristics which are isotropic in the film plane, the intensity of the bias magnetic field with respect to the angle θ of the magnetizing direction changes like a cosine curve, so that good controllability of the bias magnetic field is obtained, and the component of the magnetic field in the longitudinal direction of the magnetic field of the MI element with magnetizing angle θ can be controlled more accurately.

Next, a manufacturing method of a magnetic sensor element of the invention is explained.

First, a hard magnetic film 2 having in-plane isotropy, an insulating layer 3 covering the top of the hard magnetic film 2, and a soft magnetic film 4 placed on the insulating layer 3, are formed in order on a nonmagnetic substrate 1.

As a method of forming the hard magnetic film 2 having the desired planar shape, for example, photolithography may be used to provide a resist pattern on the nonmagnetic substrate 1, with an opening formed in the portion corresponding to the hard magnetic film 2, and then sputtering or another method may be used to deposit the hard magnetic film 2 with patterning then performed by lift-off to remove the resist.

As a method of forming the insulating layer 3 covering the top of the hard magnetic film 2, plasma CVD or another method may be used to deposit an insulating material over the entire surface.

As a method of forming the soft magnetic film 4, for example, a resist pattern may be provided on the insulating layer 3 by photolithography, and sputtering of a soft magnetic metal or the like performed to deposit a soft magnetic film 4, with patterning then performed by lift-off to remove the resist.

As a method of forming a pattern of the conducting film 5 and of the electrodes 6 at both ends for electrically connecting the plurality of soft magnetic films 4 so as to connect them in series, a method may be used in which conductive material is deposited by sputtering or the like, and after providing a resist pattern by photolithography on the conducting film is obtained, wet etching is used to pattern the conducting film.

According to the present invention, a hard magnetic film 2 which extending over a range broader than a soft magnetic film 4 is placed below the soft magnetic film 4, so that when securing electrical continuity between the soft magnetic film 4 and the outside, electrical continuity with the soft magnetic film 4 can be secured via electrodes 6 provided on an insulating layer 3. If the soft magnetic film 4 were provided above the hard magnetic film 2, then the soft magnetic film 4 would be below the insulating layer 3, and in order to secure electrical continuity with the soft magnetic film 4 it would be necessary to provide an opening in the insulating layer 3. However, in the present invention the soft magnetic film 4 is above the insulating layer 3, and there is no need to provide an opening in the insulating layer 3, so that the number of processes can be reduced.

Next, a uniaxial anisotropy is imparted to the soft magnetic film 4 along the width direction of the soft magnetic film 4. As a method of imparting uniaxial anisotropy, for example, a method of performing rotating magnetic field annealing under conditions of 400°C and 3 kG, followed by static magnetic field annealing may be used. In the rotating magnetic field annealing, an inhomogeneous anisotropy induced into the soft magnetic film 4 during film deposition can be relaxed, and in static magnetic field annealing, a uniaxial anisotropy can be induced in the direction of the magnetic field applied to the soft magnetic film 4.

Next, the hard magnetic film 2 is magnetized in a direction at an angle from the longitudinal direction of the soft magnetic film 4, under a static magnetic field or a pulsed magnetic field. As a method of magnetizing the hard magnetic film 2, a method may be used in which a pulsed or DC magnetic field which is stronger than the coercivity of the hard magnetic film 2 is applied. By means of this magnetizing process, the hard magnetic film 2 becomes a thin film magnet, and acts to apply a bias magnetic field to the soft magnetic film 4. However, when magnetizing is performed under constant conditions, the characteristics of the thin film magnet vary due to variations in the film external dimensions, variations in the film thickness, variations in the film properties and composition during deposition, and other variations during manufacture. As a result, the bias magnetic field applied to the soft magnetic film 4 also varies.

In order to correct this variation, in the present invention the hard magnetic film 2 is magnetized at an angle θ from the direction of magnetic sensing of the soft magnetic film 4. In a magnetoimpedance effect element comprising a soft magnetic film having a longitudinal direction, the element has sensitivity only in the longitudinal direction without having any sensitivity in the width direction. Therefore, when the magnetizing direction of the hard magnetic film 2 is at an angle θ from the magnetic sensing direction of the soft magnetic film 4, in the magnetic field generated from the hard magnetic film 2, only the component in the sensing direction acts as a bias magnetic field. Hence by performing magnetizing of the hard magnetic film 2 while adjusting the angle θ, the required bias magnetic field can be accurately applied to the soft magnetic film 4. Here, the angle θ can be adjusted by fine adjustment of the angle of the magnetizing direction, taking into consideration variations in the film dimensions, the film property, and other parameters. In the range from 0 to 360°, when the angle θ is 90° or 270° (that is, when the magnetic sensing direction and the magnetizing direction are perpendicular), the magnetic sensing direction component of the bias magnetic field is 0, and therefore, the angle θ is selected from among angles excluding odd multiples of 90° (90°, 270°).

It is desirable that the hard magnetic film 2 be such that magnetizing is possible at an arbitrary angle by adjusting the angle θ. To this end, by using a hard magnetic film of FePt, CoPt, CoCrPt or the like having magnetic characteristics with in-plane isotropy as a hard magnetic film 2, the bias magnetic field resulting from the direction of magnetization of the hard magnetic film 2 can be controlled more accurately.

Further, as shown in FIG. 3A and FIG. 3B, by forming the planar shape of the hard magnetic film 2 to a circular or elliptical shape in order to eliminate shape anisotropy, the absolute value of the magnetic field generated from the hard magnetic film 2 is made constant regardless of the angle θ, so that the bias magnetic field according to the angle θ can be controlled more accurately.

In the present invention, a uniaxial anisotropy is imparted to the soft magnetic film 4 along the width direction thereof; however, a uniaxial anisotropy may instead be imparted to the soft magnetic film 4 along the longitudinal direction, or along a direction at an arbitrary angle. In this case, the hard magnetic film 2 is magnetized in the direction of magnetic sensing of the magnetic sensor element, that is, in the direction at an angle θ from the longitudinal direction of the soft magnetic film 4. By this means, in the magnetic field generated from the magnetized hard magnetic film 2, only the component in the longitudinal direction of the soft magnetic film 4 acts as a bias magnetic field.

In addition to an MI sensor which detects changes in impedance when an AC current is passed through the soft magnetic film, a magnetic sensor of the present invention can be applied to an MR sensor or a GMR sensor, which detect changes in resistance when a DC current is passed through the soft magnetic film, or the like.

The soft magnetic film may also be a layered film of soft magnetic film and nonmagnetic metal film or nonmagnetic insulating film. For example, a magnetoimpedance effect element employing a three-layer structure of CoNbZr/Al/CoNbZr, NiFe/Au/NiFe, or the like, or a giant magnetoresistance effect sensor made of a multilayer metal artificial lattice of Fe/Cr, Co/Cu, or the like, may be employed.

### Examples

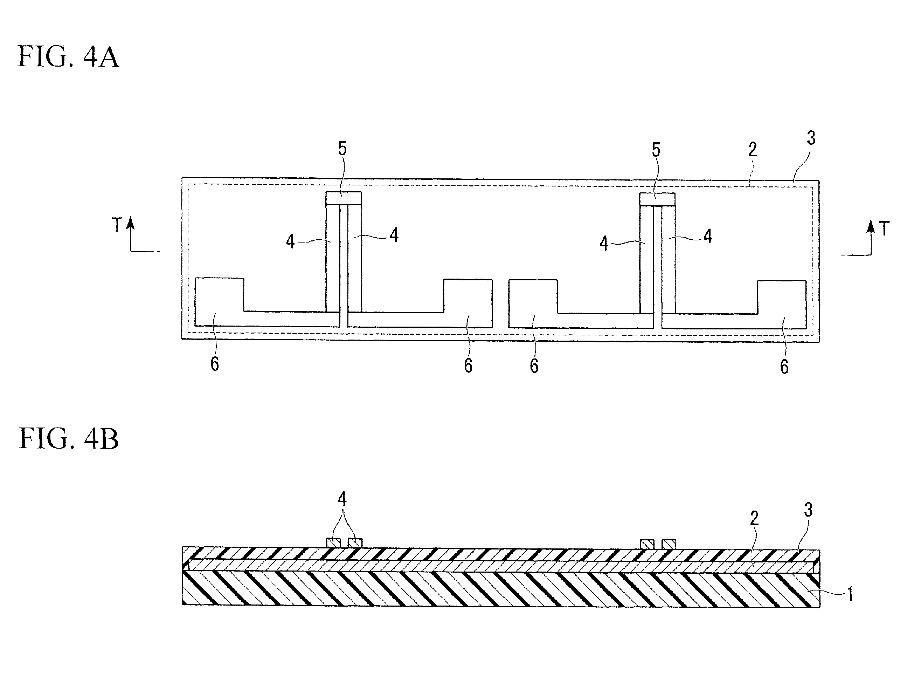

Hereinbelow, examples are used to explain the present invention in detail. However, the invention is not limited to these examples. FIG. 4A is a top view of the magnetoimpedance effect element which is manufactured by this example, and FIG. 4B is a cross-sectional view along line T-T in FIG. 4A.

A resist pattern having a substantially rectangular-shape opening corresponding to the hard magnetic film 2, is provided by photolithography on the nonmagnetic substrate 1 made of silicon. After depositing a film by sputtering FePt with a Pt composition ratio of 50%, the resist is removed by lift-off to pattern a substantially rectangular-shape hard magnetic film 2. The deposited FePt was annealed at a temperature of 600°C or higher to obtain FePt having an ordered L10 phase (L10FePt).

Next, plasma CVD was used to deposit SiO₂ over the entire face of the nonmagnetic substrate 1 so as to cover the hard magnetic film 2,and to form the insulating layer 3 covering the top of the hard magnetic film 2.

Next, photolithography is used to provide a resist pattern on the insulating layer 3, and after film deposition by sputtering of Co₈₅Nb₁₂Zr₃, the resist is removed by lift-off to form a soft magnetic film 4 with a substantially rectangular shape.

After film deposition by sputtering of Al, photolithography is used to form patterns of conducting film 5 for electrically connecting the plurality of soft magnetic films 4 so as to connect them in series as well as electrodes 6 having bonding pads for external connection at both ends.

Next, the soft magnetic film 4 formed on the substrate is subjected to rotational magnetic field annealing under conditions of 400°C and 3 kG, followed by static magnetic field annealing under the same conditions, to induce a uniaxial anisotropy to the soft magnetic film 4 in the width direction of the rectangular shape, thus obtaining a thin film-type MI element.

Next, by applying a magnetic field of 10 kOe in the direction at an angle θ from the longitudinal direction (magnetic sensing direction) of the MI element, the hard magnetic film 2 is magnetized. By passing through this magnetizing process, the hard magnetic film 2 becomes a thin film magnet, and acts to apply a bias magnetic field to the MI element. However, when the magnetizing is performed under constant conditions, then due to variations in the external dimensions of the film, variations in the film thickness, variations in the film properties and composition during sputter film deposition, and other variations at the time of manufacture, there will be variations in the characteristics of the thin film magnet, so the bias magnetic field applied to the soft magnetic film 4 will also have variations. In order to correct for these variations, the hard magnetic film 2 is magnetized at an angle θ from the magnetic sensing direction of the soft magnetic film 4.

In the magnetic sensor element manufactured by the above-described method, the size of the silicon substrate is 2.5 mm × 0.7 mm, and an L10FePt film is deposited thereupon in a region measuring 2.4 mm × 0.6 mm. The thickness of the FePt film is 1.3 µm or 2.8 µm.

The MI element made of Co₈₅Nb₁₂Zr₃ and Al electrodes is formed thereon through SiO₂ layer deposited over the entire surface of the film by PE-CVD. In the MI element, as shown in FIG. 4A, two substantially rectangular-shaped soft magnetic films 4 are electrically connected in series so as to form a pattern having a single-turn meander shape. The thickness of the soft magnetic films 4 is 1 µm, and the width of the substantially rectangular-shaped soft magnetic films 4 is 30 µm. The soft magnetic films 4 are formed to a length of 500 µm such that the longitudinal direction thereof is directed in the short-edge direction of the substrate 1 (the vertical direction in FIG. 4A).

### [Changes in magnetic field-impedance characteristic due to film thickness of the thin film magnet]

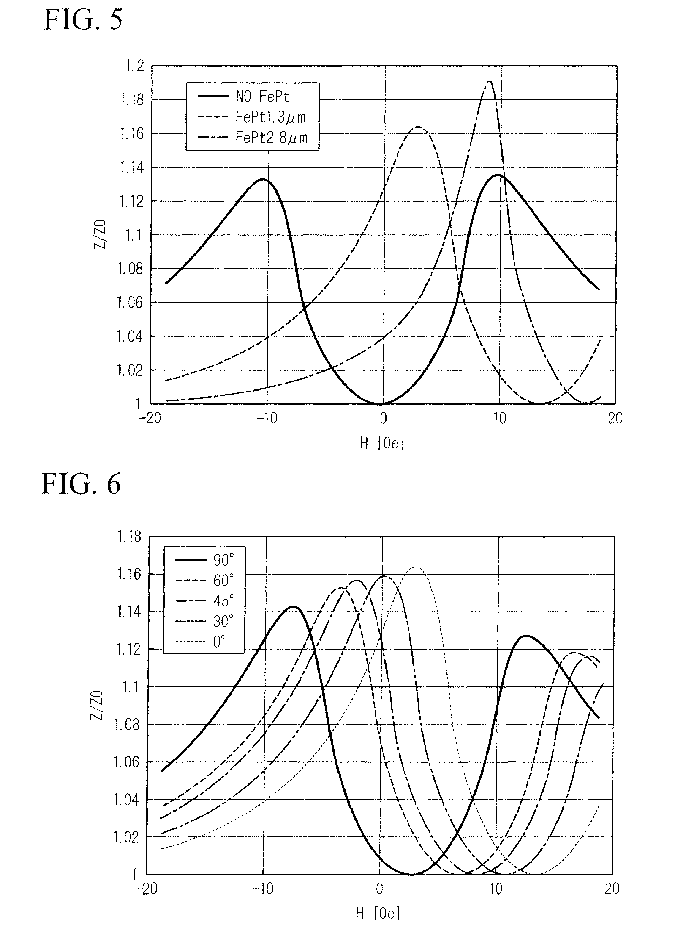

FIG. 5 shows magnetic field-impedance characteristics of MI elements when magnetized at 10 kOe, with the FePt film thickness at 1.3 µm or 2.8 µm, and the magnetizing direction of the magnet in the longitudinal direction of the MI element. In the graph of FIG. 5, "FePt 1.3 µm" is the magnetic field-impedance characteristic of an MI element with a FePt film thickness of 1.3 µm, "FePt 2.8 µm" is the magnetic field-impedance characteristic of an MI element with a FePt film thickness of 2.8 µm, and "no FePt" is the magnetic field-impedance characteristic of an MI element with the FePt film is omitted.

From the graph of FIG. 5, it is seen that by arranging the FePt in the bottom portion of the MI element, the magnetic field at which the impedance peaks is shifted to the positive magnetic field side, and an effective bias magnetic field is applied by the FePt thin film magnet. At this time, the FePt residual magnetic flux density is 1.0 Tesla for a film thickness of 1.3 µm, and is 0.6 Tesla for a film thickness of 2.8 µm; the shift amount for the bias magnetic field is 13 oersted (13 Oe) for a film thickness of 1.3 µm, and is 18 oersted (18 Oe) for a film thickness of 2.8 µm. Therefore, it is thought that the bias magnetic field shift amount is approximately proportional to the residual magnetic flux density and the film thickness of the thin film magnet. Hence it is thought that there are variations in the bias magnetic field applied to the MI element due to variations in the film thickness at the time of FePt deposition and variations in the FePt magnetic characteristics arising from the film deposition conditions.

### [Changes in magnetic field-impedance characteristic with magnetizing direction of the thin film magnet]

In order to correct variations in this bias magnetic field, the method of magnetizing the hard magnetic film in the direction at an angle θ from the longitudinal direction of the soft magnetic film is conceivable. FIG. 6 shows the magnetic field-impedance characteristic of an MI element when magnetizing the FePt by applying the magnetic field with an angle θ (here, θ = 0°, 30°, 45°, 60°, or 90°) from the magnetic sensing direction of the MI element. As shown in FIG. 6, the bias magnetic field gradually changes between magnetizing angles of 0° and 90°.

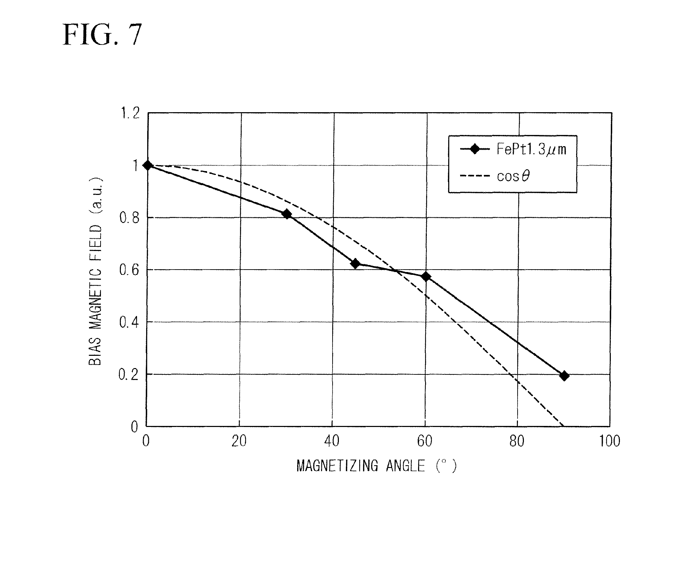

FIG. 7 is an example of the relationship between the magnetizing angle and the bias magnetic field, when the bias magnetic field is normalized by the bias magnetic field at a magnetizing direction of 0°. The cosine component of the magnetic field generated from the magnetized magnet acts as a bias magnetic field on the soft magnetic film, so that the magnetic field changes like a cosine curve with magnetizing angle. The deviation from the cosine curve is attributed to the occurrence of a shift in the direction of the magnetizing angle and the magnet magnetization, due to the demagnetizing field arising from the shape of the thin film magnet. In this embodiment, as explained above, the shape of the thin film magnet is substantially a rectangular shape, however, by forming the magnet to a circular shape, deviations between the magnetizing angle and the direction of magnetization of the magnet can be suppressed, and the bias magnetic field changes like a cosine curve in accordance with the magnetizing angle.

### INDUSTRIAL APPLICABILITY

This invention can, for example, be utilized in electronic compasses which detect the earth's magnetic field and indicate the compass directions, in rotary encoders, for biological magnetic measurements, and in other high-sensitivity magnetic sensors.

## Claims

1. A magnetic sensor element, comprising a hard magnetic film formed on a nonmagnetic substrate, an insulating layer covering the top of the hard magnetic film, and a soft magnetic film formed on the insulating layer,
wherein the magnetization direction of said hard magnetic film has an angle relative to the longitudinal direction of said soft magnetic film.

2. The magnetic sensor element according to Claim 1, wherein the region in which said hard magnetic film is formed in plan view when viewing the nonmagnetic substrate from above is broader than the region in which said soft magnetic film is formed, and the region in which said soft magnetic film is formed entirely overlaps with the region in which said hard magnetic film is formed.

3. The magnetic sensor element according to Claim 2, wherein the shape of said hard magnetic film is a circular or an elliptical shape in plan view when viewing the nonmagnetic substrate from above.

4. The magnetic sensor according to any one of Claims 1 to 3, wherein said hard magnetic film is a metal film including Co or Fe as the main component, and further including at least one of Pt and Cr.

5. The magnetic sensor according to any one of Claims 1 to 3, wherein said hard magnetic film is a metal film including FePt as the main component and having an ordered L10 phase with 35 to 55% of a composition ratio of Pt.

6. A manufacturing method of a magnetic sensor element, comprising:
a step of forming a hard magnetic film having in-plane isotropy on a nonmagnetic substrate, an insulating layer covering the top of the hard magnetic film, and a soft magnetic film with a shape in which a longitudinal direction thereof is extended in a planer direction on the insulating layer;
a step of imparting a uniaxial anisotropy along the longitudinal direction or the width direction of said soft magnetic film to said soft magnetic film by rotational magnetic field annealing followed by static magnetic field annealing; and
a step of magnetizing said hard magnetic film in a direction at an angle relative to the longitudinal direction of said soft magnetic film under a static magnetic field or a pulsed magnetic field.
